(19) Europäisches Patentamt / European Patent Office / Office européen des brevets

(11) **EP 2 955 528 B1**

(12) **EUROPEAN PATENT SPECIFICATION**

(45) Date of publication and mention
of the grant of the patent:
**01.05.2019 Bulletin 2019/18**

(21) Application number: **13866598.9**

(22) Date of filing: **02.12.2013**

(51) Int Cl.:
*H04Q 9/00* *(2006.01)*        *G08C 23/04* *(2006.01)*
*G01R 11/04* *(2006.01)*     *G01R 11/24* *(2006.01)*
*G01R 22/06* *(2006.01)*

(86) International application number:
**PCT/CN2013/088291**

(87) International publication number:
**WO 2014/101630 (03.07.2014 Gazette 2014/27)**

(54) **NEAR-INFRARED READING DEVICE AND AMMETER**

NAHINFRAROT-LESEVORRICHTUNG UND AMPEREMETER

DISPOSITIF DE LECTURE DANS LE PROCHE INFRAROUGE ET AMPÈREMÈTRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2012 CN 201210590532
10.10.2013 CN 201320624204 U
10.10.2013 CN 201320623309 U
10.10.2013 CN 201320623324 U**

(43) Date of publication of application:
**16.12.2015 Bulletin 2015/51**

(73) Proprietor: **Holley Technology Ltd.
Yulang District
Hangzhou
Zhejiang 310023 (CN)**

(72) Inventors:
• **SONG, Xiqiang
Hangzhou City
Zhejiang 310023 (CN)**
• **SHEN, Wei
Hangzhou City
Zhejiang 310023 (CN)**
• **GUO, Junfeng
Hangzhou City
Zhejiang 310023 (CN)**
• **JIANG, Dachuan
Hangzhou City
Zhejiang 310023 (CN)**
• **CHEN, Kai
Hangzhou City
Zhejiang 310023 (CN)**

(74) Representative: **2s-ip Schramm Schneider
Bertagnoll
Patent- und Rechtsanwälte Part mbB
Postfach 86 02 67
81629 München (DE)**

(56) References cited:
CN-A- 103 076 474        CN-A- 103 513 074
CN-A- 103 513 075        CN-A- 103 513 077
CN-U- 202 119 810        CN-U- 202 119 810
CN-U- 202 522 623        CN-U- 202 522 623
JP-A- 2006 023 116

EP 2 955 528 B1

## Description

## FIELD OF THE INVENTION

The present invention relates to utility power measuring technology for a residential power grid, and in particular, relates to a near-infrared reading device, and a smart watt-hour meter mated with said device.

## BACKGROUND OF THE INVENTION

Watt-hour meter is a kind of electrical metering equipments that may meter and transmit the power consumption consumed by users resided within the power grid generally by sampling the analog quantity of the current and voltage carried on the power line of the power grid and then obtaining the signals of the analog quantity of the current and voltage, thereby processing the analog values of the current and voltage to calculate data information. With upgraded improvement for the grid distribution, the electrical metering equipments for the utility users are gradually improved, and many kinds of smart electrical metering equipments such as smart meters or multi-tariff payment type meters that appear gradually to satisfy requirements of said grid. For single-phase type meters now, there is improved and optimized operating performance continuously which, however, generates more and more problems like its increasing manufacturing cost and design complication as well as some unnecessary functions that are even not utilized efficiently by the utility users. Meanwhile, most meters are designed regardless of anti-tamper function that merely is replaced by reinforced meter box thereon with little work. Even meter with anti-tamper function of no significant effect is also developed by utility manufacturers, which however realized anti-tamper functions by providing seals for the meter housing only. China patent disclosure CN202159083U disclosed a kind of anti-tamper meter with a battery supply circuit connected with a processor and a metering chip. However, the aforementioned matters only disclosed a method or procedure for determine whether sudden outages occurs by detecting the current on live line, thereby hardly resolved said outages and constant metering operations under the outage. Uncertainty even exists in the technical principle of the aforementioned method or procedure for the reason that individual cases of electric tamper are not roundly considered, that is, for tamper issues, in case of reversing conductive polarities or shorting circuits occurs, not only the neutral line are destroyed, which causes the battery supply circuit to lose the described effects.

Additionally, in the prior art, the data programming operation to the meters is realized by using a near-infrared reading device; an infrared magnetic attraction that is made of iron is fixed at inner or outer lateral of a meter housing on top of a near-infrared luminescent transistor, and the near-infrared reading device is arranged with a magnetic ring which attracts onto said magnetic attraction when reading of the metering data is needed. The defect of the art involves high cost due to the use of said infrared attraction on the meter housing and the magnetic ring within said reading device; large volume and quality of said reading device, besides strong magnetism sensibility of the magnetic ring even increasing the volume and quality of said reading device.

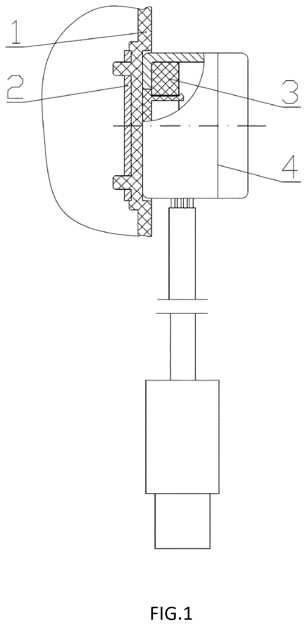

As illustrated in FIG. 1, in a conventionally near-infrared reading device, an infrared attraction 2 being made of iron is fixed at inner or outer lateral of a meter housing 1 on top of a near-infrared luminescent transistor, and the near-infrared reading device 4 is arranged with a magnetic ring 3 which absorbs onto said magnetic attraction when reading of the metering data is needed. The defect of said configuration involves high cost due to the use of said infrared attraction on the meter housing and the magnetic ring within said reading device; large volume and quality of said reading device, besides strong magnetism sensibility of the magnetic ring even increasing the volume and quality of said reading device.

The effective communication for conventional near-infrared reading requests aligning the infrared emitter of a reading device with the infrared receiver of equipment being read. Meanwhile, the definitions for the positions of the infrared emitter and the infrared receiver as defined in IEC specification and ANSI specification respectively are on the contrary, which results in devices that meet individual specifications should be distinguished as the infrared devices are designed.

The power supply in a conventional utility meters can only output single energized power so that its output capacity, which maximum outputting power equals to the value of the limit current multiplying with the clamp voltage in said power supply loop, is limited. Besides, due to high resistive load or short load, its supply voltage will decrease, disabling of micro-controller unit (MCU) operation. The low power industrial frequency transformer and the AC-to-DC switch power supplying for a conventional meters are only suitable for the power source conditions under 220VAC in that incorrect connection with a power source under 380VAC may damage the power supply. Incorrect connections or direct neutral line interrupt under 380VAC source should cause to damage all kinds of the devices that is not adapted to 380VAC request. Meanwhile, the resistance and capacity stepdown circuiting applied in a conventional meters is always designed regardless of any electrical isolation, which can hardly meet the conditions for RS485 application and results in dangerous of electric shock hazard. The conventional relay control circuit needs to select a relay with various specifications, such as 3.3V, 5V, or 12V, wherein the increased supply current equals to the consumed current by said relay.

CN 202 119 810 U relates to an infrared reading head of an electronic electric energy meter, comprising an infrared reading head body, whereof one end is fixed with a boss and the other end is provided with a data interface.

## SUMMARY

The technical problem to be solved by the present invention is to provide for an infrared reading device with small volume, light quality and low cost.

This problem is solved by the subject matter as defined in the independent claims. Accordingly provided is:

A near-infrared reading device, configured to communicatively couple with an infrared communicator in a meter, comprises a near-infrared reading device body, wherein a data port is disposed at one end of said body.

On one end of said near-infrared reading device a reading portion housing, in which a reading portion is arranged, is set, wherein the reading portion is connected with the data port.

In another preferred embodiment, said reading portion includes a DSP, a signal emitter, a signal receiver, a slope comparator and a TXD signal shield, wherein said DSP emits and transmits an infrared signal to the infrared communicator in a meter through the signal emitter and signal receiver, and the slope comparator, with the TXD signal shield coupled, is interposed between the signal emitter and signal receiver.

In another preferred embodiment, the near-infrared reading device further comprises a power supply for providing energized voltage to the DSP, signal emitter and signal receiver is connected to said data port to gaining external energized power from the data port.

The data port being selected from one of an aviation or USB port.

In another preferred embodiment, said signal emitter comprises an infrared emitter arrays, and switches Q1 coupled individually therewith, the signal emitters are controlled by a TXD signal terminal of said DSP via the switches Q1, thereby further controls said infrared emitter arrays which comprises a plurality of infrared transistors set in parallel and symmetry mutually.

In a preferred embodiment, said switch is selected from a triode transistor Q1.

In a preferred embodiment, said signal receiver comprises a booster and an infrared receiver transistor T1 coupled therewith, wherein the infrared signal generated by the infrared communicator of an electric meter is received by the infrared receiver transistor T1.

In one preferred embodiment, wherein said booster is selected from a boost resistor R4.

In one preferred embodiment, the input of said slope comparator is connected to the signal receiver, and comprises:

an under-controlled switch, which is connected to said signal receiver, according to the signal from the infrared receiver T1 of the signal receiver, enabling of controlling post-stage circuits thereafter to switch on or off;

A booster, which is connected to said under-controlled switch to boost or buck a signal that is obtained through said switch to a first level upon its switching on or off, respectively;

a voltage divider, which is connected to also said under-controlled switch to obtain a second level by dividing said signal that is obtained through said switch;

a comparator U1B, which collects said first level from the booster and the second level from the voltage divider as a positive terminal and a negative terminal respectively to determine a digital signal for a RXD signal terminal of said DSP.

In one preferred embodiment, said under-controlled switch is selected from diodes D7 and D9 mutually connected in parallel; said booster is a resistor R8; and said voltage divider is a division resistors R6 and R12.

In one preferred embodiment, a capacitive component that is connected in parallel with said voltage divider is provided, the capacitive component charges or discharges during the switch act of the under-controlled switch to produce a constant difference between said first and second levels.

In one preferred embodiment, wherein said capacitive component is a capacitor C2.

In one preferred embodiment, wherein said TXD signal shield is connected to said TXD signal terminal of the DSP and further controls said slope comparator. The TXD signal shield comprises:

A switch, which is connected to said TXD signal terminal to control the post-stage circuits in-according to the electrical level of the TXD signal terminal;

A booster, which is connected to said under-controlled switch to boost or buck the signal that is obtained from the switch;

a voltage divider, which is connected to the under-controlled switch to provide for a second level by dividing said signal that is obtained from the switch;

a comparator U1A, which collects said first level from the booster and the second level from the voltage divider as a positive terminal and a negative terminal respectively to determine a digital signal for controlling the slope comparator.

In one preferred embodiment, said under-controlled switch is selected from diodes D7 and D9 which are mutually connected in parallel; said booster is a resistor R8; and said voltage divider is a divider resistance R6 and R12.

In one preferred embodiment, wherein said switch is diodes D8, said booster is boost resistor R11, and the voltage divider is divider resistance R9 and R10.

Preferably, the meter housing is mated with the near-infrared reading device aforementioned, wherein a plurality of iron cylinders are secured in the meter housing, while the orientations of said iron cylinders and said magnetic cylinders are aligned with each other and may be magnetically attached together.

Preferably, in the central portion of the inner side of said meter housing is set with a locating slot. Preferably, a limiting slot is set within the inner side of said meter housing, wherein the locating slot is suited in the bottom surface of said locating slot.

Preferably, said iron cylinders located on both side of said locating slot, and the outer surface of said iron cylinder is flush with the bottom surface of the limiting slot.

By adopting the above subject matters, the advantages of present invention realizes, in one aspect, lower cost by displacing the infrared attraction with iron cylinders and displacing the magnetic rings in the near-infrared reading device with magnet cylinders; and in another aspect, reduced volume and lighter quality.

The second embodiment of the invention provides with a single-loop and single-phase meter, being aimed to overcome the above technical defects. The improvement of an anti-tamper meter interposed between a grid power line and utility user's load, comprises a meter housing and a near-infrared reading device mated therewith, in the meter housing there is disposed with conductive terminals, a processor, and an infrared communicator electrically connected to the processor, the live (L) and neutral (N) line of said power line are fed into the meter through the terminal, and the meter further comprise a resistance and capacitance step-down circuitry (RCSC), an analog input, a power tester, and a strong magnet tester, wherein said conductive terminals are connected to the analog input and the RCSC respectively; said analog input is electrically connected to said processor, and the RCSC is electrically connected to said processor through said power tester and strong magnet tester respectively; while corresponding connection is formed between the infrared communicator and the near-infrared reading device for available of infrared coupling there between.

In one preferred embodiment, within said meter housing a plurality of iron cylinders located on the orientation aligned with said magnetic cylinders secured within said near infrared reading device and attracting therewith, is fixed.

In one preferred embodiment, wherein said conductive terminals comprise an L input, an N input, an L output and an N output, wherein the L and N input both are connected to the grid power line; and the L and N outputs are both connected to the utility user's loads, said L input is branched to the N input and L output, respectively, further to the N output; alternatively, said conductive terminals comprises an L input, an N input, an L output and an N output, and further comprises a ground, wherein the L and N inputs are both connected to the grid power line, while the L and N outputs are both connected to the utility user's load, said L input is shunted to the N input and L output, further to the N output, respectively, said ground is connected to the N input.

In one preferred embodiment, wherein said analog input includes a manganin current transformer (CT) of L input interposed between said L input and N output, a CT of N input, and a POTENTIAL transformer (PT) each input interposed between said L input and N input, respectively, and output individually being connected to said processor.

In one another preferred embodiment, said analog input includes a manganin CT of L input, a CT of N input and a PT, wherein, the input of manganin CT is interposed between said L input and N input, while the inputs of the CT of N line and PT, are interposed between the L input and N input. The output of said manganin CT of L input, the current sampler of N line and the PT are connected to the processor, respectively.

In one preferred embodiment, said step-down circuitry includes a RC step-down circuitry (RCSC), a current sampler and a voltage stabilizer, the input of said RCSC is connected to said L input, and the input of the voltage stabilizer is electrically connected to said RCSC and current sampler, and the output of the voltage stabilizer is electrically connected to said power tester.

In another preferred embodiment, said step-down circuitry includes a RCSC and a voltage stabilizer, the input of said RC step-down circuitry is connected to said L input, and the input of the voltage stabilizer is electrically connected to said RCSC and current sampler respectively, and the output of the voltage stabilizer is electrically connected to said power tester.

In another preferred embodiment of said anti-tamper meter, said step-down circuitry includes a RCSC, a current sampler circuitry and a voltage stabilizer circuit, wherein the input of the RCSC is connected to the L input, while the input of the voltage stabilizer circuit is electrically connected to the RCSC and the current sampler circuit respectively, and the output of the voltage stabilizer circuit is connected to the power tester.

In another preferred embodiment of said anti-tamper meter, wherein said conductive terminals comprises a L input and a N input, both of which is connected to the grid power supply line, and comprises a L output and a N output, both of which is connected to the grid user load, and further comprises a ground. Said L input is branched to connect with the N input and L output respectively, and further connect to the N output.

In another preferred embodiment of said anti-tamper meter, said analog input includes a manganin CT, of L input of which input being interposed between the L input and the N output, a CT of N input, and a PT, wherein the inputs of the CT of N input and the PT are interposed between said L input and N input; the manganin CT of L input, the CT of N input and the PT are all connected to said processor via their outputs.

In another preferred embodiment of said anti-tamper meter, said ground is connected to N input.

In another preferred embodiment of said anti-tamper meter, wherein said step-down circuitry includes a RCSC, the input of which being connected to said L input, and a voltage stabilizer circuit, the input of which being connected to said RCSC, and the output of the voltage stabilizer circuit is electrically connected to the power tester.

Further provided is a watt-hour meter, interposed between a power grid line and a utility user's load, comprises abovementioned near-infrared reading device and a meter housing mated therewith, within the meter housing a processor and an infrared communicator electrically connected to the processor are set; in the meter housing a plurality of iron cylinders are set, and in the near-infrared reading device a plurality of magnetic cylinders are set, the orientations of said iron cylinders and said magnetic cylinders are aligned with each other and may be attracted together.

Further provided is a watt-hour meter, interposed between a power grid line and a residential user's load, comprises abovementioned near-infrared reading device and a meter housing, which is fitted with the near-infrared reading device, and in which a processor and an infrared communicator electrically connected thereto are set; in the meter housing a plurality of iron cylinders are set, and in the near-infrared reading device a plurality of magnetic cylinders are set, the positions of said iron cylinders and said magnetic cylinders are corresponding to each other and may be attracted together.

In one embodiment, wherein said power supply includes a step-down circuitry comprising n segments of RCSC sequentially cascaded, each of which includes a resistor that is connected to a L line of the power grid line and a capacitive component that is connected to said resistor in series, and a bi-directional TVS transistor coupled to the capacitive component, wherein the AC current from the L line of the power grid is limited through said resistor and capacitive component, and then the AC current of the L-line is clamped through said bi-directional TVS transistors and flows back to the N-line of the power grid.

In one embodiment, wherein the meter further includes bridge rectifiers and a galvanostatic charge-discharge unit connected thereto, the bridge rectifiers and charge-discharge unit is coupled to the rare end of each bi-directional TVS transistor.

Advantage of the invention is obvious: the power supply in a conventional utility meters can only output single energized power so that its output capacity, which maximum outputting power equals to the value of the limit current multiplying with the clamp voltage in said power supply loop, is limited. Besides, due to high resistive load or short load, its supply voltage will decrease, disabling of microcontroller unit (MCU) operation.

The segments-type RCSC of the present invention obtain n-way rectifier by connecting a plurality of commutating and voltage-stabilizing circuit to the RCSC circuit in series, the biggest output capacity of the DC power supply in each circuit equals to the value of a limit current multiplying with a clamp voltage in each circuit. The biggest output power of the power supply is n times of the same of the conventional RCSC. Multiple loads can be connected to the segments-type RCSC circuits independent from each other, and a large resistance load will not impact on the microcontroller, thereby improving system reliability.

The low-power industrial frequency transformer and the AC-DC switch power supply in conventional meters are only suitable for the conditions under 220VAC, while incorrect connection with 380VAC power grid will damage the power supply. When the output of the power gird is 380VAC, which is due to incorrect connections or broken neutral line, all of the devices that is not adapted to 380VAC will be damaged. The present invention uses a high AC voltage safety capacitors, thereby under the state of misconnection with the 380VAC, the power grid still can be used normally. Based on the determined result of the rare-end microcontroller, the relay output can be cut off to protect the rear-end heating plate, motor and other equipment that is intolerant with 380VAC.

The resistance voltage reduction method of the conventional meters is without electrical isolation function, which can hardly meet the conditions for RS485 supply, and results in dangerous of electric shock hazard. The present invention uses an isolated fly back power supply to supply power to RS485, RS232, MBUS circuits or button circuits, or other circuit which should be isolated, thereby preventing accidentally electric shock.

The conventional relay control circuit needs to select relays of different specifications, such as 3.3V, 5V, or 12V, and the increased supply current equals to the consumed current by said relay. The delay-equivalent BUCK topology structure used in the present invention, by changing the
duty cycle of the PWM wave, may drive various specifications of relay under one voltage, thereby greatly improves the universality of the relay, and the current consumed by the relay/the current increased by the power supply=1: the duty ratio of the PWM, the current power increased is less than the current consumed by the relay, thereby reducing the power consumption when the relay is picked up.

Many aspects of the invention can be better understood with reference to the following drawings. The components in the drawings are not necessarily to scale, emphasis intend being placed upon clearly illustrating the principles of the invention. Moreover, in the drawings like reference numerals designate corresponding parts throughout the several views.

**BRIEF DESCRIPTION OF THE DRAWINGS**

Figure 1 shows a schematic diagram of the conventional near-infrared reading device;
Figure 2A is a schematic diagram of the near-infrared reading device of the present invention;
Figure 3 is a schematic diagram of the near infrared reading device body;

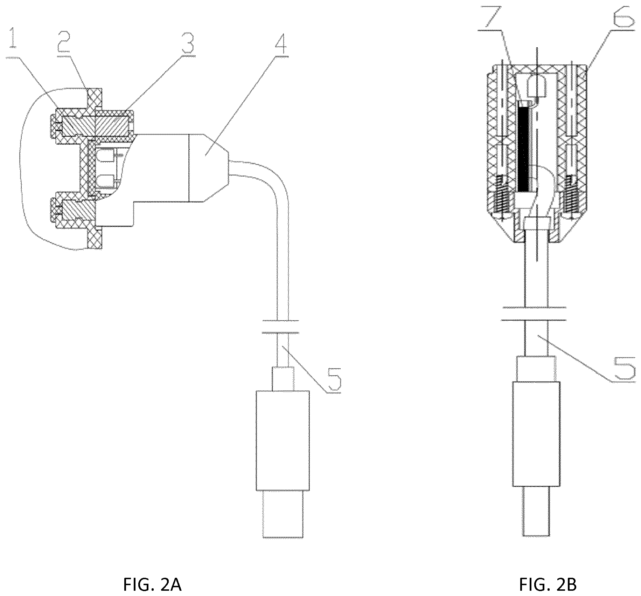

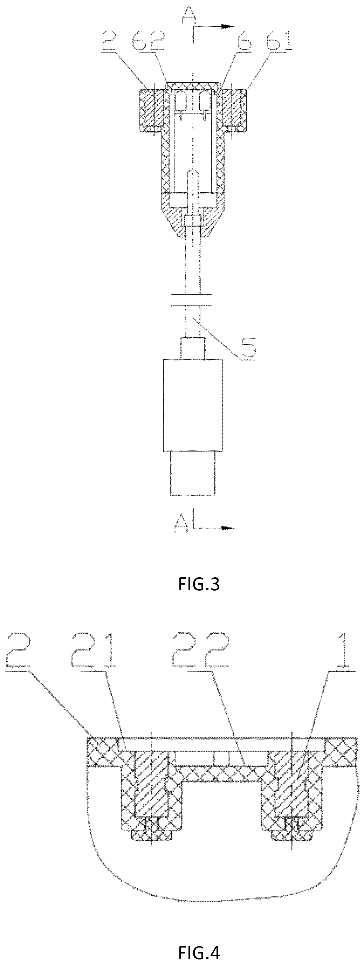

Figure 2B is an A-A sectional view in Figure 3;
Fig. 4 is a section view of the meter housing;

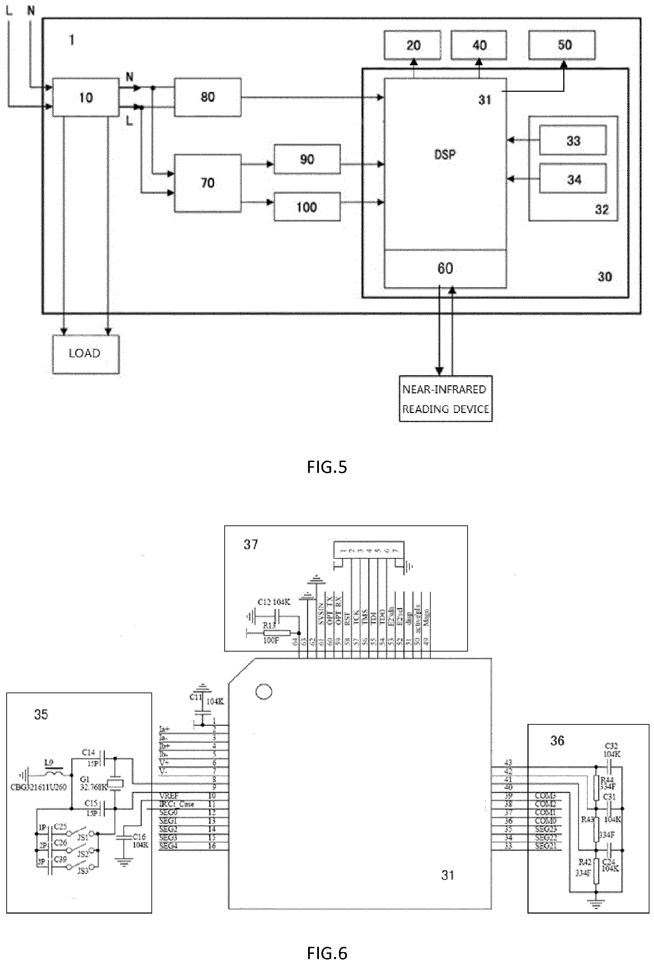

Figure 5 is the schematic diagram of the single-loop and single-phase anti-tamper electricity meter;
Figure 6 is a schematic circuit diagram of the processor in the single-loop and single-phase anti-tamper electricity meter;

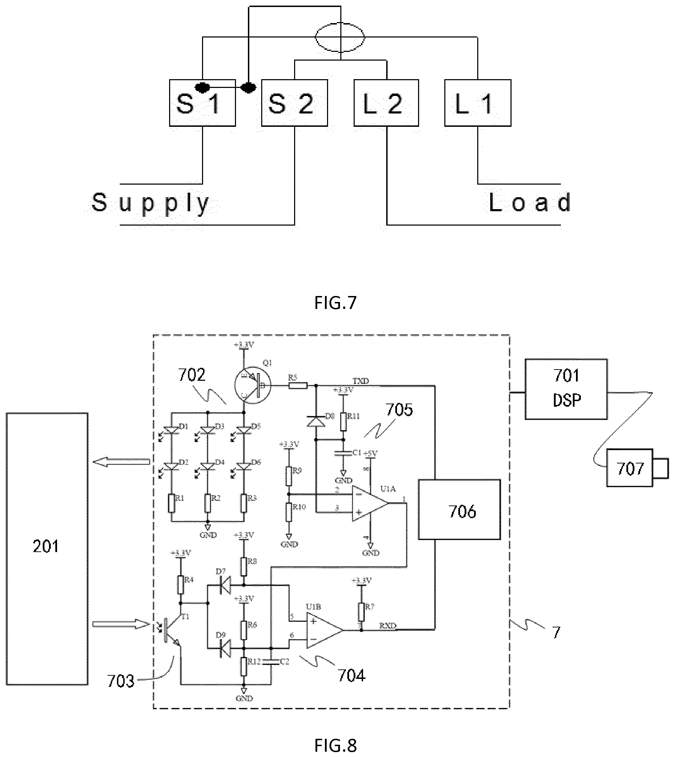

Figure 7 is a Wire map of the terminal wiring according to one preferred embodiment;

Figure 8 is the main schematic circuit diagram of the reading portion according to the near-infrared reading device of the near-infrared reading device.

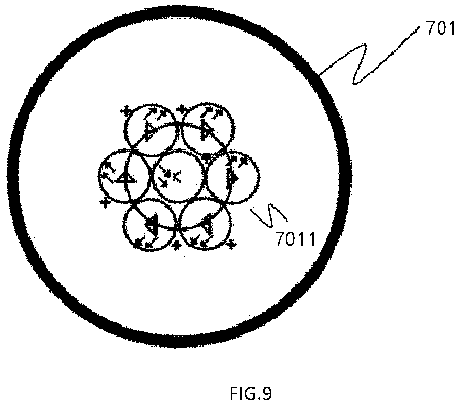

Figure 9 illustrates the infrared emission transistor radically arranged in the reading portion.

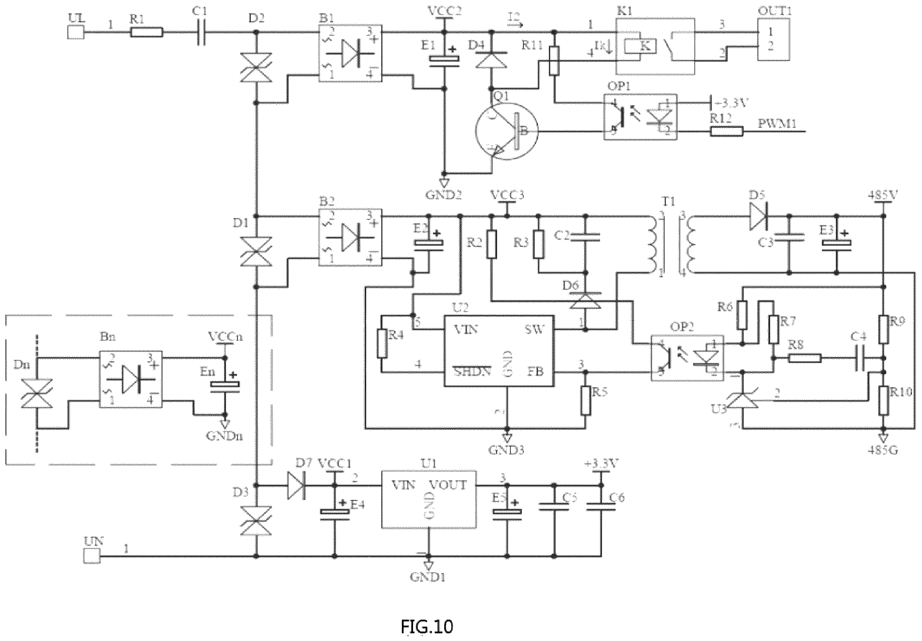

Figure 10 is the main circuit diagram of the power supply according to the present invention.

## DETAILED DESCRIPTION OF THE PREFERRED EMBODIMENTS

The detailed embodiments are further described with the accompanying drawings.

Fig.2 shows a near-infrared reading device of one preferred embodiment of the present invention, the near-infrared reading device comprises a main body 4, on end of which being disposed with a magnetic cylinder 3, on the other end of which being disposed with a data port 5. A plurality of iron cylinders 1 are located in a meter housing 2, while the orientations of said iron cylinders 1 and said magnetic cylinders 3 are aligned with each other and may be attracted together.

As shown in Fig 3 and Fig 2B, at one end of the near-infrared reading device body 4, there is disposed with a reading portion housing 6 in which there is disposed with a reading portion 7. A lug 61 with a slot is set at each lateral of said reading portion housing 6, respectively, and the magnetic cylinder 3 is secured in the slot. As shown in Fig.4, two iron cylinders 1 are set in the meter housing 2 for coupling with the magnetic cylinders. A boss 62 is set in the central top of said reading portion housing, the inner side of the meter housing is designed with a locating slot 22 corresponding to the position of the boss 62. A limiting slot 21 is set within the inner side of said meter housing, and the locating slot 22 is positioned in the bottom surface of said locating slot 21. Preferably, said iron cylinder1 is located on both side of said locating slot 22, and the outer surface of said iron cylinders 1 is flush with the bottom surface of the limiting slot 21.

In the near-infrared reading device of the present invention, the infrared iron attraction in prior art is displaced with iron cylinders, the iron cylinders are secured within the meter housing of the meter with inlay, heat melting, press fit procedure and so on, and the magnetic cylinders are secured within the lugs of the reading portion housing with press fit, when data reading is needed, the magnetic cylinders and the iron cylinders can be aligned and attached with each other. Said data port is selected from one of an aviation plug and an USB port, or other kinds of data port.

The near-infrared design of the meter housing may be compatible with the conventional and improved near-infrared reading devices, the meter housing provides position for the near-infrared reading device, the limiting slot is used for the conventional near-infrared reading devices and the locating slot is used for the improved near-infrared reading device. The original position above the infrared luminescent transistor of the meter housing that was used to position the near-infrared attraction is displaced into a iron cylinder, and the iron cylinder may be secured to the meter housing by inlay, heat melting and press fit and so on, and the outer end face of the iron cylinder is flush with the bottom surface of the plastic to increase the attraction.

A magnetic cylinder is used to displace the magnetic ring of the conventional near-infrared reading device, and the magnetic cylinder is secured to the reading portion housing through press-fit process, the volume of the magnetic is greatly smaller than the magnetic ring, thereby the cost being greatly decreased. The lid of the reading portion may be secured by a bolt, and may be secured by ultrasonic welding, snap joint or glue. The near-infrared reading portion device can be easily attached to the meter housing to read the data through aligning the magnetic cylinder and the iron cylinder and inserting the protruded part of the reading portion housing into positioning slot. The improvement of near-infrared reading device is suitable for the other meters with near-infrared iron attraction. The data port may be selected from an aviation or an USB port, or other data port.

Referring to the Fig 2A, Fig 2B and Fig.5, in the embodiment of an improved anti-tamper meter, the meter comprises a meter housing 2 and a near-infrared reading device 4 mated with the meter housing 2, in the meter housing 2 a connection terminal, a processor, and an infrared communicator that is electrically connected to the processor are set, the L and N line of said power supply line are fed into the meter through the terminal, and the meter further comprises a step-down circuitry, an analog input portion, a power tester, and a strong magnet tester, wherein said conductive terminals is connected to the analog input portion and the step-down circuitry respectively; said analog input is electrically connected to said processor, and the step-down circuitry is electrically connected to said processor through said power tester and strong magnet tester respectively; while corresponding connecting is formed between the infrared communicater and the near-infrared reading device, and communication coupling between the same two is realized through infrared communication.

In one embodiment, a single-loop and single-phase anti-tamper meter interposed between a grid power line and utility user's loads, comprises conductive terminal(s) 10, a display 20, a processor 30, a memory 40, an input circuit 50 and an infrared communication circuit 60. The display 20, memory 40, input circuit 50 and infrared communication circuit 60 are electrically connected to the processor 30, and the L line and N line of said power supply line are fed into the meter 1 through the terminal 10. The meter further comprises a step-down circuitry 70, an analog input circuit 80, a power testing circuit 90, and a strong magnet testing circuit 100, wherein said connection terminal 10is connected to the analog input circuit 80 and the step-down circuitry 70 respectively; said analog input circuit is electrically connected to said processor 30, and the step-down circuitry 70 is electrically connected to said processor 30 through said power tester circuitry and the strong magnet testing circuit respectively.

In one preferred embodiment, referring to Fig.2A and Fig.2B, a plurality of iron cylinders 1 is located in the meter housing, and a plurality of magnetic cylinders 3 is secured in the infrared reading device 4, the orientations of said iron cylinders 1 and said magnetic cylinders 3 are aligned with each other and may be attracted together. On one end of main body 4 of the near-infrared reading device a reading portion housing 6, in which being disposed with a reading portion 7, is set, and the reading portion 7 is connected with a data port 5.

In one preferred embodiment of the single-loop and single-phase anti-tamper meter according to the present invention, the processor 30 includes a microcontroller 31 and a switch 32 that is connected to the microcontroller 31.

All of the components used in the single-loop and single-phase anti-tamper meter according to the present invention is integrated entirely in PCB circuit board in contrast to the conventional meter's configuration integrated the memory 40, display 20 and the processor 30 in one circuitry board, while the remaining components set onto several boards, thus increasing the cost and conduction stability. The advantage of the present invention is to overcome the defects by novel connecting and installing method thereof.

The microcontroller 31 is preferably selected from the MSP430F427-type 16-bits MCU produced by TI Co, Ltd, and preferably provides a metering unit (preferably to be ESP430A1) and an ADC circuit. As shown in the Fig. 5, the L line and the N line is connected to the step-down circuitry 70 and the analog input circuit 80 respectively, then the step-down circuitry 70 and the analog input circuit 80 transmit the analog signal of the current I and the voltage U to the microcontroller 31, and the ADC circuit of the microcontroller 31 converts the signal to a digital signal and send it to the metering unit, the metering unit comprises a pair of register, namely a current register and a voltage register, to execute a dual channel metering, and get the metering power demand by the following formula:

$$P_{TOU} = \Sigma U_{TOU} \cdot I_{TOU};$$

Wherein, the demand is defined by the value of the electrical power that is accumulated in a demand cycle dividing the time quantity of demand cycle. When the demand cycle is finished, the demand value may be compared with the largest demand of active/apparent power in the communicative channel, if the demand is too large, then new largest demand and time thereof are to exchange said demand and its time, respectively. In the preferred embodiment of the invention, the demand is calculated in intervals manner, for example, the demand metering objects include the total largest demand and occurring time thereof, the active or apparent power under existing demand, and corresponding occurring time in a 30min interval. Meanwhile, a metering unit on this PCB executes bi-directional metering, that is, the positive electrical power value is the sum of the absolute values from the positive and negative value of the metered utility power.

In one preferred embodiment of the single-loop and single-phase anti-tampered meter according to the present invention, the memory 40, the display 20 or the infrared communicator 60 is respectively electrically connected to the microcontroller 31. Referring to Fig.2, the infrared communicator 60 can be coupled with the microcontrollers 1, that is, be integrated within the processor 30.

In one preferred embodiment of the single-loop and single-phase anti-tampered meter according to the present invention, the switch circuit 32 includes an unpowered metering switch 33 and unpowered displaying switch 34, the unpowered metering switch 33 and the unpowered displaying switch 34 are respectively connected to the microcontroller 31.

As shown in Figure 6, in one preferred embodiment of the single-loop and single-phase anti-tampered meter according to the present invention, the processor 30 further comprises a clock 35 that is electrically coupled with the processor 30, a bias circuit 36 and a programmer 37. The clock 35 preferably includes a crystal oscillator that is set to be at 32.768K, thereby making the overall error in 1 year be less than ls. The bias circuit 36 is utilized to regulate the function terminals of the processor 30 of the meter 1, while the programmer 37 preferably is arranged inside the processor 30 and coupled with the microcontroller 31, the programmer 37 can also be arranged on the infrared communicator 60, in one embodiment of the present invention, the clock 35 may be controlled by the programmer 37, for example, an external communication equipment. Preferably, an infrared reading device 62 is used to optically communicate with the clock 35 to calibrate the time and the date that are calculated by the clock, or when the data of the meter 1 is read from the electrical metering data of the microcontroller 31, time-sharing or segmental reading according to the control of clock should be carried on.

As shown in the Fig.7, in the first preferred embodiment of the single-loop and single phase anti-tamper meter according to the present invention, said conductive terminals comprises an L input S1 and an N input S2, both of which are connected to the grid power supply line SUPPLY, and comprises an L output S3 and an N output S4, both of which are connected to the grid user load LOAD. Said L input S1 is branched to connect with the N input S2 and L output S3, and further connect to the N output S4.

In the first preferred embodiment of the single-loop and single phase anti-tamper meter according to the present invention, said analog input circuit 80 includes a manganin CT of L line, the input of which is interposed between the L input S1 and the N output S4, a CT, and a potential transformer, the input of the N line, CT of N line and the potential transformer are interposed between said L input S1 and N input S3; the L line manganin CT of L line, the CT of N line and the potential transformer are all connected to said processor 30 with their output.

In the first preferred embodiment of the single-loop and single phase anti-tamper meter according to the present invention, wherein said step-down circuitry 70 includes a RC step-down circuitry, the input of which being connected to said L input S1, a current sampler circuit and a voltage stabilizer circuit, the input of which being connected to said RC step-down circuitry and the current sampler circuit, and the output of the voltage stabilizer circuit is electrically connected to the power tester 90.

In the second preferred embodiment of the single-loop and single phase anti-tamper meter according to the present invention, wherein said connection terminals 10 comprises an L input S1 and an N input S2, both of which are connected to the grid power supply line, and comprises an L output S3 and an N output S4, both of which are connected to the grid user load, and further comprises a ground S5. Said L input S1 is branched to connect with the N input S2 and L output S3, and further connect to the N output S4.

In the second preferred embodiment of the single-loop and single phase anti-tamper meter according to the present invention, said analog input circuit 80 includes an L-line manganin CT, the input of which is interposed between the L input S1 and the N output S4, an N-line CT, and a voltage transformer, the input of the N-line CT and the voltage transformer are interposed between said L input S1 and N input S2; the L-line manganin CT, the N-line CT and the voltage transformer are all connected to said processor30 with their output.

In the second preferred embodiment of the single-loop and single-phase anti-tamper meter according to the present invention, said ground S5 is connected to the N input S2.

In the second preferred embodiment of the single-loop and single phase anti-tamper meter according to the present invention, wherein said step-down circuitry 70 includes a RC step-down circuitry, the input of which being connected to said L input S1, and a voltage stabilizer circuit, the input of which being connected to said RC step-down circuitry and the output of the voltage stabilizer circuit is electrically connected to the power testing circuit 90.

In the second preferred embodiment of the single-loop and single phase anti-tamper meter according to the present invention, wherein said infrared communicator further comprises an infrared communication port for electrically connecting with an near-infrared reading device 4.

In the second preferred embodiment of the single-loop and single phase anti-tamper meter according to the present invention, wherein said infrared communication port and said external data reader port are engaged with each other and transfer data through infrared communication.

In the second preferred embodiment of the anti-tamper meter according to the present invention, wherein said input circuit 50 comprises a display and a programming circuit.

In the second preferred embodiment of the single-loop and single phase anti-tamper meter according to the present invention, wherein said display is disposed with a display control key and is connected to said microcontroller 31.

In the second preferred embodiment of the single-loop and single phase anti-tamper meter according to the present invention, wherein said programmer is disposed with a programming control key and is connected to said microcontroller 31.

Further, a power testing method for the above-mentioned single loop and single phase anti-tamper meter includes the following steps:

1. initiating the meter;

2. detecting the power supply type by the microcontroller 31, if the detecting result give a grid line power supply type, then performing powering initialization operation, however, if the detecting result a battery power supply type, then performing unpowering initialization operation;

3. after power initialization , starting the powering cycle; after the unpowering cycle , starting a unpowering cycle;

4. after the powering cycle, carrying out unpowering detection, if powered state of the meter is detected, then performing the powering cycle again; if the unpowered state is detected, performing the unpowering initialization operation; after the unpowering cycle, the powering test is executed, if the unpowering state is detected, carrying out the unpowering cycle, and if the powered state is still detected, then performing the powering test back again.

In the preferred embodiment of said power testing method for the above motioned single-phase and single line anti-tamper meter, the powering cycle includes, in a predetermined time period, performing sequentially: 1, metering processing; 2, display processing; 3, event processing; and communications processing.

In a preferred embodiment of said power testing method for the above motioned single-phase and single line anti-tamper meter, the unpowering cycle includes, in a predetermined time period sequentially: 1, unpowering detection processing; 2, tamper event processing; 3, interrupting processing.

Referring to the Fig. 2A, Fig. 2B, a near-infrared reading device, configured to communicatively couple with an infrared communicator of a meter, comprises a near-infrared reading device main body 4, wherein a data port 5 is disposed at one end of said main body.

One end of said near-infrared reading device body 4 is provided with a reading portion housing 6, in which a reading portion 7 is provided, and the reading portion 7 is connected with the data port 5.

Referring to Fig.8, In one preferred embodiment, said reading portion7 includes a DSP (digital signal processor) 706, a signal emitter 702, a signal receiver 703, a slope comparator 704 and a TXD signal shield 705, wherein, wherein said DSP 706 transmits and receives infrared signal to the infrared communicator 201 of a meter through the signal emitter 702 and signal receiver 703, and the slope comparator 704,with the TXD signal shield 705 coupled, is interposed between the signal emitter 702 and signal receiver 703.

In one preferred embodiment, the near-infrared reading device 101 further comprises a power701 which is supplied for providing operating voltage to the DSP 706, signal emitter 702 and signal receiver 703, and connected to the USB data port to gather external +12V energized power from the data port 707.

In one preferred embodiment, the data ports selected from one of an aviation plug or USB port, generally the USB port, and the aviation plug may be used if the meter is an industrial instrument.

Further referring to Fig.8, in one preferred embodiment, said signal emitter 702 comprises an infrared emitter arrays, and switches coupled individually therewith (preferably to be atriodeQ1), the signal emitter are controlled by a TXD signal terminal of said DSP via the switches Q1, thereby further controls said infrared emitter arrays, which comprises a plurality of infrared emitter transistors set in parallel and symmetry mutually.

A preferred embodiment of signal transmitter 702, as shown in Fig. 8,consists of resistors R1, R2, R3, R5, infrared emission transistors D1, D2, D3, D4, D5, D6 (infrared emitter D1 and D2, D3 and D4, D5 and D6 are mutually connected to each other forming several arrays), and a triode Q1. Normally, the TXD signal terminal is set to a high level, the base signal that is input to the PNP type triode Q1 through the resistor R5 by the TXD terminal signal is at a high level, making the TXD terminal stop, then the infrared emission transistors D1, D2, D3, D4, D5, D6 cease to emit infrared signals. When the TXD signal is set to a low level, the base signal that is input to the switch pipe Q1 through a resistor R5 by the TDX signal terminal is at a low level, then turning the Q1 on, and the +3.3V supply voltage from the power 701 flow through transistors D1, D2, R1, D3, D4, R2, and D5, D6, R3, and the infrared emission transistors D1, D2, D3, D4, D5, D6 emits infrared signal to the electric meter.

At the same time, relating to the design of PCB, the infrared emission transistor D1, D2, D3, D4, D5, D6 forms a central symmetry arrangement, and the infrared emission transistor is designed to possess a conical emission angle, so that the infrared communicator 201 can receive infrared signals with enough strength, ensuring the reliability of the emitted signal regardless of position of the infrared communication port is orientated.

In a preferred embodiment, the signal receiving part comprises a boost device (R4 resistance) and a infrared receiver T1 that is connected with the boost device, the infrared signal of the infrared communicator 201 is received by the infrared receiver T1.

A preferred embodiment of the signal receiver 703 is shown in the Fig. 8, which is mainly composed of a resistor R4 and an infrared receiver T1.

Among them, when no infrared emission signal is transmitted to the communicator 201, the infrared receiver T1 is cutoff, and the collector of T1is boosted up to a high level by a resistance R4. When the infrared signal that is transmitted by a meter that is not center-aligned is received, the infrared receiver T1 is got into an enlarging state, wherein the collector of T1 is under a uncertain low level state, under this situation, the collector voltage is related to the infrared intensity and the infrared divergence angle of the infrared emission transistor, when infrared intensity of the infrared emission transistor gradually increases and the infrared divergence angle becomes larger and larger, the collector voltage becomes more and more close to 0V. When the infrared communicator 201 of the meter finishes the infrared emission, the voltage of the collector of the T1 is boosted to 3.3V by the resistor R4.

In one preferred embodiment, the input of the slope comparator 704 is connected into the infrared receive transistor T1 of the signal receiver 703, and the meter comprises: under-controlled switch component (preferably to be diodes D7, D9), which is connected to the signal receiving component 703 and controls the on-off state of its post-stage circuit in response to the infrared receiver T1; a booster (R8), which is connected with the under-controlled switch component (diode D7) to boost or buck the signals that is obtained by the on-off control to the first level +3.3V; a voltage divider (divider resistance R6, R12), which is connected to the under-controlled switch to obtain a second level (smaller than +3.3V, the measured value is +3.0V) by dividing said signal that is obtained through the on-off operation; a comparator U1B, which functions said first level from the booster and the second level from the voltage divider as a positive terminal and a negative terminal respectively to determine a digital signal for a RXD terminal of the DSP 706.

In one preferred embodiment, a capacitive component(a capacitor C2) that is connected in parallel with said voltage divider (a resistor R12)is provided, the capacitive component charges or discharges during the on-off process of the diodes D7 and D9to produce a constant difference value 0.3V between the first level +3.3V and the second level +3.0V.

One preferred embodiment of a slope comparator 704 is given in Fig 8, the slope comparator 704 may consist of resistors R8, R6, R12, R7, diodes D7, D9, a capacitor C2 and a comparator U1B.

When no infrared signal is received by the infrared receiver T1, the infrared receiver T1 output a high level, and the diodes D7, D9 are cut off. The input of the comparator U1B is boosted to +3.3V by the resistor R8 boost up to +3.3V voltage, and voltage of the negative terminal of the comparator U1B is divided by the R6 and R12 to obtain a voltage approximating +3.3, at this moment, the positive terminal voltage of the comparator U1B is larger than the voltage of the negative terminal, and the comparator U1B outputs are pulled-up up to a high levelly the resistor R7, the output of RXD signal is at a high level.

When the infrared receiver T1 receives the infrared signal, T1 begins to get into an enlarging state, the collector voltage begins to decrease, and the diodes D7, D9 begins to power on, the positive terminal and the negative terminal descend due to the powering of the diodes D7,D9.But because the reasons for the existence of the negative end of the capacitor C2, the positive terminal voltage of U1B decreased faster than the negative end, followed by a short work period, the positive terminal voltage is lower than the negative terminal voltage, U1B output low level, and the RXD signal terminal begins to jump from high level to a low level.

When the collector of the infrared receiver T1 maintains at a low level, for the reason that the currents flow through the on-off switches D7, D9 are different, and the pressure drop of the on-off switches D7, D9 are different too (pressure drop of D7 is less than D9), the positive terminal voltage is less than the negative terminal voltage, the comparator's output U1B is detained at a low level, the RXD signal terminal continues to output a low level signal. When the T1 stops receiving the infrared signal, the infrared receiver T1 begins to change to the cutoff state instead of the enlarging state, the collector voltage of T1 rises to +3.3V, the positive side voltage of the switches D7 and D9 begins to rise; because the resistor R6 needs to charge the capacitor C2, the rising rate of the negative terminal voltage of said comparator U1B is slower than its positive terminal voltage, then, in a very short work period, the positive terminal voltage of comparator U1B is higher than its negative terminal voltage that causes the comparator U1B outputs a high level by a resistor R7, and the RXD terminal outputs a high level.

In a preferred embodiment, the TXD signal shield 705 is connected to the TXD signal terminal of the DSP terminal, and controls the slope comparator 704, the TXD signal shield includes: a switching device (diode D8), which is connected into the TXD signal terminal and further controls rare-stage circuit according to the level of the TXD signal terminal; a boost device (Boost resistor R11), which is connected with the controlled switch device, and pulls up or pulls down the signals that is obtained through the on-off control to a first level +3.3V; divider components (divider resistance R9, R10), which are connected with the under-controlled switch component to divide the signal that is obtained by on-off control to obtain a second level +2.4V; a comparator U1A, which takes said first level from the booster and the second level from the voltage divider as a positive terminal and a negative terminal respectively to determine a digital signal output of the digital signal controlled slope comparator.

One preferred embodiment of a TXD signal shield 705 is shown by Fig. 8, which is composed of resistors R11, R9, R10, a capacitor C1, a diode D8 and a comparator U1A. Because the analog signal distance, the transmitted intensity of the infrared receiver T1 are various, the conventional comparator cannot deal with the digital signal, so the embodiment of this slope comparator is thus designed.

When the TXD is high, the switch D8 is closed, the positive input voltage of the comparator U1A is boosted to +3.3V through the resistor R11, and the negative input voltage of the comparator U1A is obtained through dividing +3.3V by the R9 and R10. At this moment, the U1A positive terminal voltage is higher than the negative terminal voltage, the comparator U1A outputs a high resistance state, thereby no longer controls the negative terminal of the slope comparator, and no longer detects any change in the slope of the analog signal.

For example, A and B points are selected and detected from a analog signal waveform, wherein A point indicates a point where the voltage begins to descend, and B point likewise indicates a point where the voltage begins to ascend that, on mapping in the quadrant coordinates, are expressed by lines in first and fourth quadrants respectively, wherein the ascending line with positive slope lies in the first quadrant, where the comparator's output is at a high level. Meanwhile, the descending line with negative slope lies in the fourth quadrant, where the comparator's output is at a low level. In the case of constant high or low voltage, the slope is 0, the comparator's output then may not change.

When the TXD outputs low level, the switch D8 is closed, the positive terminal voltage is bucked down by the D8 to be less than the negative terminal voltage, the comparator outputs a low level, the negative terminal of the slope comparator U1B is bucked down to a low level, and then the positive input voltage of the U1B is greater than the negative terminal input voltage of the U1B constantly, causing U1B to output high level, and then RXD is high. When the TXD signal surges from the low to a high level, the switch D8 is cut off again. However, charging of the capacitor C1 through the resistor R11, enabling the voltage thereof being higher than the negative input of the U1A, would run a time period, which hence ensures that after the exchange of the TXD, a delay, resulting from the switch-off time of the infrared receiver being larger than the infrared emitter, generated by the infrared receiver due to the junction capacity effect is shielded by said TXD signal. Thereby, there will not appear any immediately low level pulse at the TXD terminal after the TXD surges to a high level. When the communicator receives an infrared signal emitted by the meter, the TXD signal shield has already lost the control to the negative terminal of the slope comparator which thereby can process any infrared signal received by the infrared receiver.

Based on the description above-mentioned, a meter is provided by the present invention interposed between the power grid line and the utility user's loads, as shown in the Fig. 2A, Fig. 2B and Fig. 2, and comprises a meter housing 2, within which is disposed with a processor and a infrared communicator 201 electrically connected to the processor, wherein a plurality of iron cylinders 1 is located in the meter housing 2, and a plurality of magnetic cylinders 3 is secured within the infrared reading device, the orientations of said iron cylinders 1 and said magnetic cylinders 3 are aligned with each other and may be attracted together.

A method for a meter to initiate near-infrared communication with an external device includes the following steps:

> 1) connecting the meter to an external data device for gathering external energized power through a data port of a near-infrared reading device;

> 2) aligning a boss set on one end of said near-infrared reading device with a corresponding limiting slot within said meter housing and inserting the boss into the limiting slot, thereby coupling the near-infrared communicator in the meter communicatively with said reading portion;

> 3) transmitting reading request from the external data device to said infrared communicator through the reading portion: setting the TXD signal terminal to a low level by the DSP, and inputting a low level to the switch of the signal emitter to power it on through a resistance R5, and then enabling the power supply to provide a first level for the infrared emitter arrays, so as to transmit infrared signal to said infrared communicator;

> 4) using the processor of the meter to receive said infrared signal via said infrared communicator and then feeding data signal back to the data receiver;

> 5) receiving said data signal fed back from said processor via the infrared receiver T1 of said signal receiver, wherein, the infrared receiver T1 is under amplification state, and the collector of the infrared receiver T1 is under a uncertain low level state, at this moment, the voltage above the collector is proportional to the infrared emission intensity and infrared emission angle; when the infrared emission intensity or infrared emission angle of the infrared communicator increase, the voltage above the collector tends to be 0V; when the infrared communicator finishes transmitting the data signal, the voltage of the collector in the infrared receiver is boosted to the first level through the booster;

> 6) transmitting said data to the external data device via said data port.

In one preferred embodiment of said meter, wherein in step 3), when the signal from the TXD signal terminal is not received by the signal emitter, the DSP set the signal to a high level and input a high level to the switch of signal emitter via the resistor R5 to turn it off; and in step 5), the voltage of collector in the infrared transistor T1 is restrained to said first level by the booster when the data signal from the infrared communicator is not received.

In one preferred embodiment, the infrared receiver T1 gets into an enlarging state when receiving the fed data signal, and the collector voltage begins to descend to cause the under-controlled switch of said slope comparator turn-on, and in turn, cause the first and second level received by the positive and negative of said comparator U1B descend, respectively; it is made that controlling the descending rate of voltage of the positive terminal of said comparator U1B to be larger than voltage of the negative terminal by a capacity component, so as to ensure that the output of the comparator U1B is at a low level, and to ensure that RXD signal terminal begins to abruptly descend from high voltage to a low level; when the collector voltage of the infrared receiver T1 maintains at a low level, the voltage of positive terminal of said comparator U1B is smaller than the negative terminal thereof, thereby makes the output of comparator U1B maintained at a low level, and in turns make sure that the output of RXD signal terminal continue to maintain at a low level;

the infrared receiver T1 changes to be in a turn-off state from the enlarging state since stopping receiving the fed data signal, and the collector voltage begins ascending up to said first level, which in turn, causes the voltage of the positive terminal of said under-controlled switch beginning to ascend; it is made that charging said capacitive component by several divider resistance so that controlling the descending rate of the voltage above the negative terminal of said comparator U1B being smaller than the positive terminal thereof, and the output of said comparator U1B outputs a high level through a booster resistance, while the RXD terminal outputs a high level.

In one preferred embodiment, the switching component of said TXD signal shield initiates to be in a cutting-off state when the TXD signal terminal of the DSP is set to be at a high level thereby makes the voltage of the positive input of said comparator U1A be boosted to a first level, wherein the voltage of negative terminal of said comparator U1A is a second level that is obtained by dividing said first level via divider resistance, meanwhile, the voltage value of positive terminal of said comparator U1A is larger than negative terminals so as to disable of said comparator U1A for controlling the negative terminal of said slope comparator; it is made that turning the switch component of said TXD signal shield on when the TXD signal terminal of the DSP is set to be at a low level, thereby setting the voltage of the positive terminal of said comparator U1A to a value being smaller than the voltage of the negative terminal and outputting a low level; the negative terminal of said comparator U1B at said slope comparator is bucked down to a low level, thereby, the voltage of the positive input is constantly larger than the negative terminal input voltage for outputting a high level, and the RXD terminal outputs a high level.

Referring to the Fig. 2A and Fig. 2B, one preferred embodiment of the near-infrared reading device, which is used to communicate with the infrared communicator, is provided, the reading device comprises a main body 4, on one end of which there is disposed with a data port 5, on the other end of body 4 there is provided with a reading portion housing 6 within which is provided with a reading portion 7, and the reading portion 7 is connected with the data port 5.

In one embodiment, the reading device further comprises a power supply, which provides +12V DC voltage to the reading portion, and further connects to the data port 5 to obtain the external 220V AC power source through the data port 5.

Referring now to figure 9, in one embodiment, the reading portion 7 comprises a circular arrangement of a plurality of infrared emission transistors 701, wherein each infrared emission transistor 7011 has a conical emission angle set in the range of 30 to 75 degrees.

In a preferred embodiment, the conical emission angle is 60 °.

In another embodiment, again referring to figure 2A, a near infrared communication type meter includes aforementioned near-infrared reading device, and the meter housing 2 that is matched with asid reading device, in the housing 2 there is provided with a processor and a infrared communicator(s), the infrared communicator is electrically connected to the processor, wherein the housing is secured with a iron cylinder 1, the near infrared reading device is provided with magnetic cylinder 3 therein, and the orientation of the cylinder 1 and the magnetic cylinder 3 are aligned with each other and can be attracted together.

Referring to figure 10, in one embodiment, the power supply circuit comprises a step-down circuitry, a rectification and stabilization circuitry, a PWM relay controller, and a FLYBACK step-down circuitry.

In one embodiment, the power supply includes a RC step-down circuitry unit, the step-down circuitry unit is composed by n-segments RCSC , each RCSC comprises a resistor connect to the L input of the power grid line and a capacitive device connected to said resistor in series, and a bi-directional TVS transistor(s) connected to the capacitive, the AC current from L line is limited through the resistor and capacitive devices, then flows back into the N line after clamp effect by the bi-directional TVS transistor..

RCSC:

Consisting of a winding resistor R1, high-voltage safety capacitor C1, bi-directional TVS transistors D1, D2, and D3. An AC current from live line is limited through the R1 and C1 and clamped through the transistors D1, D2, and D3 to neutral line. Each transistor D1, D2, or D3 has a bi-directional clamp characteristics, allowing for outputting a peak-to-peak AC voltage drop that equals to TVS clamp therefrom, thereby providing for the loads in its post-stage loop after rectification and stabilization process in each loop. As more power output needed, there is avail continuously applying any bi-directional TVS transistor Dn into the RCSC in series.

Multi-loop rectification and stabilization circuitry:

consisting of bridge rectifier B1, B2, a rectifier diode D7, electrolytic capacitors E1, E2, E4, E5, a regulator U1, and chip capacitors C5, C6. AC voltage from transistor D2 is processed with full-wave rectification via bridge B1 and with filter via capacitor E1 to obtain a AC voltage VCC2 in turn being provided for a PWM relay controller. AC voltage from transistor D1 flows is processed with full-wave rectification and with filter via capacitors E2 to obtain a AC voltage VCC3 in turn being provided for an isolated FLYBACK step-down circuitry. AC voltage from transistor D3 is processed with half-wave rectification via diode D7 and with filter via capacitor E4 to obtain a AC voltage VCC1 in turn being stabilized via the regulator U1 and filtered via sequentially the elements E5, C5, C6 to obtain a voltage of 3.3V that is to be provided for the microcontroller. As more power output needed, it is available that AC voltage from transistor Dn may be rectified via another bridge Bn and filtered via another capacitor En to obtain an AC voltage VCCn in turn being provided for its post-stage loads.

PWM relay controller:

consisting of a relay K1, an optical coupler OP1, a triode Q1, a flywheel diode D4, and resistors R11, R12. When the relay is deactivated, output of PWM1 states at a high level, there is no current flowing through the coupler OP1 disabling of its output, and then the triode Q1 is cut off, and coil K1 in which no voltage drop generates is switched off. When the relay is activated, the PWM1 outputs a PWM signal, the input of the coupler OP1 is switched on or off according to the said PWM signal, and then the output of said coupler OP1 also is switched on or off according to the PWM signal. The AC current VCC2 flows through elements R11 and OP1 to base of said triode Q1 that is thus switched on or off according to the PWM signal. As the triode Q1 is switched on, the diode D4 is cut off, wherein the current VCC2 flew through the coil K1 is $I_{k_1}$. As the triode Q1 is switched off, the current $I_k$ of the K1 cycles back to point VCC2 through the diode D4. The average current at point VCC2 is $I_2$, the cycle period of the PWM signal is T, and the switch-on time is $T_{on}$. In accordance with the regulation of power at point VCC2 multiplying with a efficiency $\eta$ =K1, the current $I_2$ can be calculated as the following relation:

$$I_2 = \ (I_k \cdot T_{on}) \ / \ (T \cdot \eta),$$

In one embodiment, a circuiting test result shows that: $\eta=0.9$, $I_2=1.1 Ik \cdot T_{on}/T$, it is assumed that the activated voltage of the relay K1 is $V_{K1}$, then its duty cycle is $T_{on}/T=V_{K1}/V_{CC2}$.

The subject matter of said relay features equivalent to a BUCK topology structure for changing the duty cycle of the PWM wave to drive various kinds of relay under same voltage condition, thereby greatly improving the universality of the relay, and it is achieved that the current consumed by the relay/the current boosted by power supply = 1: the duty cycle of the PWM, the boosted current is less than the current consumed by the relay thereby reducing the power consumption while the relay being switched on.

isolated FLYBACK step-down circuitry:

consisting of resistors R2, R3, R4, R5, R6, R7,R8, R9, R10, diodes D6, D5, a high-frequency transformer T1, an optical coupler OP2, a switching step-down circuitry (SSC) U2, a potential reference U3 , chip capacitors C2, C3, C4, and an electrolytic capacitor E3. Voltage VCC3 provides energized power to the SSC U2 through VIN terminal thereof and couples to an enable terminal SHDN of the SSC U2 through the resistor R4 while powering the system of the invention to initiate said chip U2. At this moment, the output of said coupler OP2 is deactivated, and a feedback terminal FB of said circuit U2 is boosted down by the resistor R5 thereby causing said chip U2 to determine that the output voltage has still not reached a predetermined value, allowing for switching a SW terminal of said SSC U2 on and off repeatedly. As the SW terminal is activated, the current VCC3 flows through the 1st and 2nd windings of the transformer T1 for charge operation. According here to the definition of the homonymous windings, the 3rd terminal of the transformer T1 is at a negative level unavailable of the diode D5. As the SW terminal is deactivated, the current through said 1st and 2nd windings of the transformer T1 continues to flow along the elements D6, R3, C2 back to point VCC3, and the homonymous terminal of said transformer T1 and the corresponding 3rd terminal thereof is respectively at a positive level, and the diode D5 is activated for charging the capacitances C3, E3, the voltage 485V thus is rising. The voltage 485V provides energized power to the voltage reference U3 through resistors R6, R7, the reference U3 determines the voltage 485V divided by the resistors R9, R10. Elements R8 and C4 are used to execute phase adjustment to improve the response characteristic of said reference U3.

When the voltage value at point 485V increases up to 5V, the 1st terminal of the reference U3 outputs a low level, the output of said coupler OP2 is activated. The current VCC3 flows to the feedback terminal FB of chip U2 since divided by components R2, OP2, and R5. The SW terminal of the chip U2 is deactivated, thus there has no energy across said transformer T1, the voltage 485V begins to decrease, the 1st terminal of the reference U3 outputs a high level, and the coupler OP2 is deactivated, thereby decreasing the voltage of FB terminal of the chip U2, and switching the SW terminal of the chip U2 repeatedly on and off again. The voltage 485V finally is stabilized at a pre-set value owing to said repeat.

The foregoing disclosure is not intended nor is to be construed to limit the present invention or otherwise to exclude any such other embodiments, adaptations, variations, modifications and equivalent arrangements, the present invention being limited only by the claims appended hereto and the equivalents thereof.

## Claims

1. A near-infrared meter reading device, configured to communicatively couple with an infrared communicator in a meter, comprising a main body (4) thereof, wherein a data port (5) being disposed in one end of said main body (4); a housing (6) for a reading portion (7), within which said reading portion (7) being set, is suited on one end of said main body; wherein said reading portion includes a digital signal processor (31), a signal transmitter (702), a signal receiver (703), a slope comparator (704) interposed between said signal transmitter (702) and signal receiver (703), and a transmit data TXD signal shield (705) in communication with said slope comparator (704), wherein said digital signal processor (31) transmitting an infrared type signal to the infrared communicator of a meter, respectively, or receiving said signal therefrom by its signal transmitter (702) or signal receiver (703).

2. The near-infrared meter reading device of claim 1, wherein said signal transmitter (702) including infrared emitter arrays, and corresponding switches (Q1) coupled individually thereto via which said signal transmitter (702) being controlled by a TXD signal terminal of said digital signal processor (31) and thereby controlling said infrared emitter arrays that consisting of a plurality of infrared transmitting transistors set in parallel and symmetry mutually.

**3.** The near-infrared meter reading device of claim 1, wherein said signal receiver (703) including a booster and a plurality of infrared receivers (T1) via which said signal receiver (703) being to receive infrared signal generated from the infrared communicator in the meter.

**4.** The near-infrared meter reading device of claim 1, wherein said slope comparator (704), which input being connected to said signal receiver (703), includes:

an under-controlled switch being connected to said signal receiver, and enabling of controlling post-stage circuits thereafter to switch on or off upon the signal from said infrared receiver (T1); a booster being connected to said under-controlled switch to boost or buck a signal therefrom to a first level; a voltage divider being connected also said under-controlled switch to obtain a second level by dividing said signal; and a comparator (UIB) collecting said first level from the voltage booster and second level from the voltage divider, respectively, to serve as a positive input and a negative input to determine a digital signal for an RXD signal terminal of said digital signal processor (31).

**5.** The near-infrared meter reading device of claim 4, further including a capacitive unit connected in parallel with said voltage divider being in charge or discharge stage to derive a contact difference between said first and second level.

**6.** The near-infrared meter reading device of claim 1, wherein said TXD signal shield (705) connected to said TXD signal terminal of said digital signal processor (31) and further configured to control said slope comparator, includes:

a switch connected to said TXD signal terminal to control post-stage circuits thereafter in correspond to the signal therefrom; a booster connected to said under-controlled switch to boost or buck said signal to a first level upon its switching on or off, respectively; a voltage divider connected also to said under-controlled switch to provide for a second level by dividing said signal; a comparator (UIA) collecting said first level from the voltage booster and second level from the voltage divider serving as a positive input and a negative input, respectively, to its inputs to determine a digital signal output for controlling said slope comparator, .

**7.** An anti-tamper meter, interposable between a grid power line and utility user's load by feeding live (L) line and neutral (N) line of said grid power line through a plurality of conductive terminals (10) in said meter, comprising a meter housing (2) and a near infrared reading device (4) according to one of the preceding claims mated and communicatively coupled therewith for infrared communication there between, in the meter housing (2) there is secured with said conductive terminals (10), a processor (30), and an infrared communicator (60) electrically connected to said processor (30), further a step-down circuitry (70), an analog input (80), a power tester (90), and a strong magnet tester (100), wherein said conductive terminals (10) are connected to the analog input (80) and the step-down circuitry (70) respectively, the processor (30) being respectively connected to said analog input (80), further the step-down circuitry (70) through said power tester (90) and strong magnet tester (100), respectively.

**8.** The anti-tamper meter of claim 7, wherein within said meter housing (2) a plurality of iron cylinders (1) located on the orientation aligned with said magnetic cylinders (1) secured within said near infrared reading device (4) and attracting therewith, is fixed.

**9.** The anti-tamper meter of claim 7, wherein said conductive terminals (10) comprise a live (L) input and a neutral (N) input both connected to the grid power line, as well as a live (L) output and a neutral (N) output both connected to the utility user's load, wherein said live (L) input being shunted to the neural (N) input and live (L) output, further the neutral (N) output, respectively, or said conductive terminals (10) comprises a (L) input and a neutral (N) input both connected to the grid power line, as well as a live (L) output and a neutral (N) output both connected to the utility user's load, further comprises a ground, wherein said live (L) input is shunted to the neutral (N) input and live (L) output, further the neutral (N) output, respectively, and the ground is connected to said neutral (N) input.

**10.** The anti-tamper meter of claim 7, wherein said analog input (80) includes a manganin current transformer (CT) of live (L) input interposed between said live (L) input and neutral (N) output, a current transformer (CT) of neutral (N) input, and a potential transformer (PT) each input interposed between said live (L) input and neutral (N) input, respectively, and output individually being connected to said processor (30), or said analog input includes a manganin current transformer (CT) of live (L) input interposed between said live (L) input and neutral (N) output, a current transformer (CT) of neutral (N) input, and a potential transformer (PT) each input interposed between said live (L) input and neutral (N) input, respectively, and each output individually being connected to said processor (30).

11. The anti-tamper meter of claim 7, wherein said step-down circuitry (70) includes a resistance and capacitance step-down circuitry of which input being connected to said live (L) input, a current sampler, and a voltage stabilizer, of which input being connected to said resistance and capacitance step-down circuitry and current sampler and which output being connected to said power tester (90) respectively, or said step-down circuitry including a resistance and capacitance step-down circuitry of which input terminal being connected to said live (L) input, and a voltage stabilizer of which input terminal being connected to said resistance and capacitance step-down circuitry and which output being connected to said power tester (90), respectively.

12. A watt-hour meter, interposable between power supply line and utility user's load, comprising the near-infrared reading device according to one of claims 1 to 6 , and a meter housing (2) mated therewith, within the meter housing said conductive terminals, a processor, and an infrared communicator (201) electrically connected thereto are secured, within said meter housing a plurality of iron cylinders (1) which being located on the orientation aligned with said magnetic cylinders (3) secured within said near infrared reading device and attracting therewith, are secured.

**Patentansprüche**

1. Nahinfrarotmessgerät-Auslesevorrichtung, die dafür ausgelegt ist, mit einem Infrarotkommunikator in einem Messgerät kommunikationsgekoppelt zu sein, umfassend: einen Grundkörper (4), wobei eine Datenschnittstelle (5) in einem Ende des Grundkörpers (4) angeordnet ist; ein Gehäuse (6) für einen Ausleseabschnitt (7), in welchem der einzustellende Ausleseabschnitt (7) an einem Ende des Grundkörpers eingepasst ist; wobei der Ausleseabschnitt einen Digitalsignalprozessor (31), einen Signalübertrager (702), einen Signalempfänger (703), einen zwischen dem Signalübertrager (702) und dem Signalempfänger (703) gelegenen Neigungskomparator (704) und eine Übertragungsdaten-TXD-Signalabschirmung (705) in Kommunikation mit dem Neigungskomparator (704) umfasst, wobei der Digitalsignalprozessor (31) jeweils ein Infrarotsignal an den Infrarotkommunikator eines Messgeräts überträgt oder das Signal von diesem durch dessen Signalübertrager (702) oder Signalempfänger (703) empfängt.

2. Nahinfrarotmessgerät-Auslesevorrichtung nach Anspruch 1, wobei der Signalübertrager (702) Infrarotstrahlerarrays und entsprechende, mit diesen einzeln gekoppelte Schalter (Q1) umfasst, über welche der Signalübertrager (702) durch einen TXD-Signalanschluss des Digitalsignalprozessors (31) gesteuert wird und dadurch seinerseits die Infrarotstrahlerarrays steuert, die aus einer Mehrzahl von wechselseitig parallel und symmetrisch zueinander angeordneten Infrarotsendetransistoren bestehen.

3. Nahinfrarotmessgerät-Auslesevorrichtung nach Anspruch 1, wobei der Signalempfänger (703) einen Verstärker und eine Mehrzahl von Infrarotempfängern (T1) umfasst, über welche der Signalempfänger (703) in der Lage ist, erzeugte Infrarotsignale von dem Infrarotkommunikator in dem Messgerät zu empfangen.

4. Nahinfrarotmessgerät-Auslesevorrichtung nach Anspruch 1, wobei der Neigungskomparator (704), dessen Eingang mit dem Signalempfänger (703) verbunden ist, umfasst:

   einen untersteuerten Schalter, der mit dem Signalempfänger verbunden ist und der es ermöglicht, die nachgereihten Nachstufenschaltungen anzuweisen, ein- oder auszuschalten, wenn das von dem Infrarotempfänger (T1) kommende Signal anliegt;
   einen Verstärker, welcher mit dem untersteuerten Schalter verbunden ist, um ein von dort kommendes Signal auf einen ersten Pegel aufwärts- oder abwärtszuregeln ;
   einen Spannungsteiler, welcher ebenfalls mit dem untersteuerten Schalter verbunden ist, um durch Teilen des Signals einen zweiten Pegel zu erhalten; und
   einen Komparator (UIB), welcher jeweils den ersten Pegel von dem Spannungsverstärker und den zweiten Pegel von dem Spannungsteiler erfasst, die als positiver Eingabewert und als negativer Eingabewert dienen, um ein digitales Signal für einen RXD-Signalanschluss des Digitalsignalprozessors (31) zu bestimmen.

5. Nahinfrarotmessgerät-Auslesevorrichtung nach Anspruch 4, ferner umfassend eine Kapazitätsmesseinheit, die mit dem in einer Ladestufe oder Entladestufe befindlichen Spannungsteiler parallel geschaltet ist, um eine Kontaktdifferenz zwischen dem ersten und dem zweiten Pegel abzuleiten.

6. Nahinfrarotmessgerät-Auslesevorrichtung nach Anspruch 1, wobei die TXD-Signalabschirmung (705), die mit dem TXD-Signalanschluss des Digitalsignalprozessors (31) verbunden ist und ferner dafür ausgelegt ist, den Neigungskomparator zu steuern, Folgendes umfasst:

einen Schalter, der mit dem TXD-Signalanschluss verbunden ist, um nachgereihte Nachstufenschaltungen entsprechend dem anliegenden Signal zu steuern;

einen Verstärker, welcher mit dem untersteuerten Schalter verbunden ist, um durch dessen Ein- oder Ausschalten das Signal jeweils auf einen ersten Pegel aufwärts- oder abwärtszuregeln;

einen Spannungsteiler, welcher ebenfalls mit dem untersteuerten Schalter verbunden ist, um durch Teilen des Signals einen zweiten Pegel bereitzustellen; und

einen Komparator (UIA), welcher den ersten Pegel von dem Spannungsverstärker und den zweiten Pegel von dem Spannungsteiler erfasst, die jeweils als positiver Eingabewert und als negativer Eingabewert dienen, und seinen Eingabewerten hinzufügt, um einen digitalen Signalausgabewert zum Steuern des Neigungskomparators zu bestimmen.

7. Eingriffsgesichertes Messgerät, welches zwischen einer Stromnetzleitung und einer Verbraucherseite eines Netznutzers zwischenschaltbar ist, indem der Phasenleiter (L-Leiter) und der Neutralleiter (N-Leiter) der Stromnetzleitung durch eine Mehrzahl von Leiteranschlüssen (10) in dem Messgerät hindurchgeführt werden, welches ein Messgerätgehäuse (2) und eine Nahinfrarot-Auslesevorrichtung (4) gemäß einem der vorhergehenden Ansprüche umfasst, die zusammengefügt und im Hinblick auf eine Infrarotkommunikation kommunikationsgekoppelt sind, wobei in dem Messgerätgehäuse (2) die Leiteranschlüsse (10), ein Prozessor (30) und ein elektrisch mit dem Prozessor (30) verbundener Infrarotkommunikator (60), sowie ferner eine heruntertransformierende Schaltung (70), ein Analogeingang (80), eine Stromprüfvorrichtung (90) und eine Starkmagnet-Prüfvorrichtung (100) befestigt sind, wobei die Leiteranschlüsse (10) jeweils mit dem Analogeingang (80) bzw. der heruntertransformierenden Schaltung (70) verbunden sind, und der Prozessor (30) jeweils mit dem Analogeingang (80) bzw. durch die Stromprüfvorrichtung (90) und die Starkmagnet-Prüfvorrichtung (100) ferner mit der heruntertransformierenden Schaltung (70) verbunden ist.

8. Eingriffsgesichertes Messgerät nach Anspruch 7, wobei in dem Messgerätgehäuse (2) eine Mehrzahl von Eisenzylindern (1) befestigt ist, die sich auf der Ausrichtung befinden, die mit den Magnetzylindern (1) ausgerichtet ist, welche in der Nahinfrarot-Auslesevorrichtung (4) befestigt sind, und die einander anziehen.

9. Eingriffsgesichertes Messgerät nach Anspruch 7, wobei die Leiteranschlüsse (10) einen Phasenleitereingang (L-Eingang) und einen Neutralleitereingang (N-Eingang), die beide mit der Stromnetzleitung verbunden sind, sowie einen Phasenleiterausgang (L-Ausgang) und einen Neutralleiterausgang (N-Ausgang) umfassen, die beide mit der Verbraucherseite eines Netznutzers verbunden sind, wobei der Phasenleitereingang (L-Eingang) jeweils im Nebenschluss an den Neutralleitereingang (N-Eingang) und den Phasenleiterausgang (L-Ausgang), ferner an den Neutralleiterausgang (N-Ausgang) angeschlossen ist, oder

die Leiteranschlüsse (10) einen Phasenleitereingang (L-Eingang) und einen Neutralleitereingang (N-Eingang), die beide mit der Stromnetzleitung verbunden sind, sowie einen Phasenleiterausgang (L-Ausgang) und einen Neutralleiterausgang (N-Ausgang), die beide mit der Verbraucherseite eines Netznutzers verbunden sind, und ferner einen Erdungsleiter umfassen, wobei der Phasenleitereingang (L-Eingang) jeweils im Nebenschluss an den Neutralleitereingang (N-Eingang) und den Phasenleiterausgang (L-Ausgang) und ferner an den Neutralleiterausgang (N-Ausgang) angeschlossen ist und der Erdungsleiter an den Neutralleitereingang (N-Eingang) angeschlossen ist.

10. Eingriffsgesichertes Messgerät nach Anspruch 7, wobei der Analogeingang (80) einen zwischen dem Phasenleitereingang (L) und dem Neutralleiterausgang (N) zwischengeschalteten Manganin-Stromwandler (CT) des Phasenleitereingangs (L), einen Stromwandler (CT) des Neutralleitereingangs (N) und einen Potentialwandler (PT) umfasst, wobei jeder jeweils zwischen dem Phasenleitereingang (L) bzw. Neutralleitereingang (N) und dem Ausgang zwischengeschaltete Eingang einzeln mit dem Prozessor (30) verbunden ist, oder wobei

der Analogeingang einen zwischen dem Phasenleitereingang (L) und dem Neutralleiterausgang (N) zwischengeschalteten Manganin-Stromwandler (CT) des Phasenleitereingangs (L), einen Stromwandler (CT) des Neutralleitereingangs (N) und einen Potentialwandler (PT) umfasst, wobei jeder jeweils zwischen dem Phasenleitereingang (L) bzw. Neutralleitereingang (N) und jedem Ausgang zwischengeschaltete Eingang einzeln mit dem Prozessor (30) verbunden ist.

11. Eingriffsgesichertes Messgerät nach Anspruch 7, wobei die heruntertransformierende Schaltung (70) eine heruntertransformierende Schaltung für Widerstand und Kapazität umfasst, deren Eingang mit dem Phasenleitereingang (L) verbunden ist, sowie einen Stromabtaster und einen Spannungsstabilisator umfasst, dessen Eingang jeweils mit der heruntertransformierenden Schaltung für Widerstand und Kapazität und mit dem Stromabtaster verbunden ist und dessen Ausgang mit dem Stromprüfgerät (90) verbunden ist, oder wobei

die heruntertransformierende Schaltung eine heruntertransformierende Schaltung für Widerstand und Kapazität umfasst, deren Eingangsanschluss mit dem Phasenleitereingang (L) verbunden ist, und einen Spannungsstabilisator umfasst, dessen Eingangsanschluss jeweils mit der heruntertransformierenden Schaltung für Widerstand und Kapazität verbunden ist und dessen Ausgang mit dem Stromprüfgerät (90) verbunden ist.

12. Wattstundenmessgerät, welches zwischen der Stromversorgungsleitung und der Verbraucherseite eines Netznutzers zwischenschaltbar ist und welches umfasst: die Nahinfrarot-Auslesevorrichtung nach einem der Ansprüche 1 bis 6, ein damit zusammengefügtes Messgerätgehäuse (2), wobei in dem Messgerätgehäuse die Leiteranschlüsse, ein Prozessor und ein elektrisch damit verbundener Infrarotkommunikator (201) befestigt sind, wobei in dem Messgerätgehäuse eine Mehrzahl von Eisenzylindern (1) befestigt ist, die sich auf der Ausrichtung befinden, die mit den Magnetzylindern (3) ausgerichtet ist, welche in der Nahinfrarot-Auslesevorrichtung befestigt sind, und die einander anziehen.

**Revendications**

1. Dispositif de lecture pour appareil de mesure proche infrarouge lequel est conçu pour être couplé à un communicateur infrarouge dans un appareil de mesure de manière à communiquer, comprenant : un corps de base (4), une interface de données (5) étant disposée à une extrémité du corps de base (4) ; un boîtier (6) pour une partie lecture (7) dans lequel la partie lecture (7) qui doit être réglée est intégrée à une extrémité du corps de base ; ladite partie lecture comprenant un processeur de signaux numériques (31), un transmetteur de signaux (702), un récepteur de signaux (703), un comparateur d'inclinaison (704) situé entre le transmetteur de signaux (702) et le récepteur de signaux (703) et un blindage de signaux pour données de transmission TXD (705) en communication avec le comparateur d'inclinaison (704), le processeur de signaux numériques (31) transmettant respectivement un signal infrarouge au communicateur infrarouge d'un appareil de mesure ou recevant le signal de ce dernier, et ce par l'intermédiaire de son transmetteur de signaux (702) ou de son récepteur de signaux (703).

2. Dispositif de lecture pour appareil de mesure proche infrarouge selon la revendication 1, dans lequel le transmetteur de signaux (702) comprend des dispositions d'émetteurs de rayonnement infrarouge et des commutateurs (Q1) appropriés couplés de manière individuelle avec ces derniers et grâce auxquels le transmetteur de signaux (702) est commandé par l'intermédiaire d'un port de signaux TXD du processeur de signaux numériques (31) et, de ce fait, commande à son tour les dispositions d'émetteurs de rayonnement infrarouge lesquels sont constitués d'une pluralité de transistors d'émission infrarouge disposés parallèlement les uns aux autres et symétriquement entre eux.

3. Dispositif de lecture pour appareil de mesure proche infrarouge selon la revendication 1, dans lequel le récepteur de signaux (703) comprend un amplificateur et une pluralité de récepteurs infrarouges (T1) par l'intermédiaire desquels le récepteur de signaux (703) est en mesure de recevoir des signaux infrarouges générés, provenant du communicateur infrarouge logé dans l'appareil de mesure.

4. Dispositif de lecture pour appareil de mesure proche infrarouge selon la revendication 1, dans lequel le comparateur d'inclinaison (704) dont l'entrée est reliée au récepteur de signaux (703) comprend :

   un commutateur sous-régulé qui est relié au récepteur de signaux et qui permet de commander les circuits de post-étage situés en aval de telle sorte que ceux-ci se mettent en service ou hors service lorsque le signal en provenance du récepteur infrarouge (T1) est appliqué ;
   un amplificateur qui est relié au commutateur sous-régulé afin d'augmenter ou de diminuer un signal provenant de ce dernier pour le faire passer à un premier niveau ;
   un diviseur de tension qui est également relié au commutateur sous-régulé afin d'obtenir par division du signal un deuxième niveau ; et
   un comparateur (UIB) qui saisit respectivement le premier niveau en provenance de l'amplificateur de tension et le deuxième niveau en provenance du diviseur de tension, lesquels servent de valeur d'entrée positive et de valeur d'entrée négative afin de déterminer un signal numérique pour un port de signaux RXD du processeur de signaux numériques (31).

5. Dispositif de lecture pour appareil de mesure proche infrarouge selon la revendication 4, lequel comprend en outre une unité de mesure de capacité qui est montée en parallèle avec le diviseur de tension se trouvant en un étage de charge ou en un étage de décharge afin de dériver une différence de contact entre le premier et le deuxième niveau.

6. Dispositif de lecture pour appareil de mesure proche infrarouge selon la revendication 1, dans lequel le blindage de signaux TXD (705) qui est relié au port de signaux TXD du processeur de signaux numériques (31) et qui est en outre conçu pour commander le comparateur d'inclinaison, comprend les éléments suivants :

un commutateur qui est relié au port de signaux TXD afin de commander des circuits de post-étage situés en aval conformément au signal appliqué ;
un amplificateur qui est relié au commutateur sous-régulé et qui est mis en marche ou mis à l'arrêt afin de respectivement augmenter ou diminuer le signal pour le faire passer à un premier niveau ;
un diviseur de tension qui est relié également au commutateur sous-régulé afin de fournir par division du signal un deuxième niveau ; et
un comparateur (UIA) qui saisit le premier niveau en provenance de l'amplificateur de tension et le deuxième niveau en provenance du diviseur de tension, lesquels servent respectivement de valeur d'entrée positive et de valeur d'entrée négative, et les ajoute à ses valeurs d'entrée afin de déterminer une valeur de sortie de signal numérique destinée à commander le comparateur d'inclinaison.

7. Appareil de mesure inviolable qui peut être interposé entre un câble d'alimentation secteur et un côté consommateur d'un utilisateur du réseau en faisant passer le fil de phase (fil L) et le fil neutre (fil N) du câble d'alimentation secteur à travers une pluralité de bornes conductrices (10) situées dans l'appareil de mesure, lequel comprend un boîtier d'appareil de mesure (2) et un dispositif de lecture proche infrarouge (4) selon l'une quelconque des revendications précédentes lesquels sont assemblés et couplés l'un à l'autre en vue de communiquer en utilisant une communication infrarouge, dans le boîtier d'appareil de mesure (2) étant fixés les bornes conductrices (10), un processeur (30) et un communicateur infrarouge (60) relié électriquement audit processeur (30), ainsi qu'un circuit abaisseur (70), une entrée analogique (80), un dispositif testeur de courant (90) et un dispositif testeur d'aimant fort (100), les bornes conductrices (10) étant respectivement reliées à l'entrée analogique (80) ou au circuit abaisseur (70), et le processeur (30) étant relié respectivement à l'entrée analogique (80) ou, par l'intermédiaire du dispositif testeur de courant (90) et du dispositif testeur d'aimant fort (100), au circuit abaisseur (70).

8. Appareil de mesure inviolable selon la revendication 7, dans lequel dans le boîtier d'appareil de mesure (2) est fixée une pluralité de cylindres métalliques (1) dont l'orientation se trouve dans l'alignement des cylindres magnétiques (1) qui sont fixés dans le dispositif de lecture proche infrarouge (4) et s'attirent les uns les autres.

9. Appareil de mesure inviolable selon la revendication 7, dans lequel les bornes conductrices (10) comprennent une entrée de conducteur de phase (entrée L) et une entrée de conducteur neutre (entrée N) qui sont toutes deux reliées au câble d'alimentation secteur, ainsi qu'une sortie de conducteur de phase (sortie L) et une sortie de conducteur neutre (sortie N) qui sont toutes deux reliées au côté consommateur d'un utilisateur du réseau, l'entrée de conducteur de phase (entrée L) étant connectée respectivement en dérivation à l'entrée de conducteur neutre (entrée N) et à la sortie de conducteur de phase (sortie L) et en outre à la sortie de conducteur neutre (sortie N), ou

les bornes conductrices (10) comprennent une entrée de conducteur de phase (entrée L) et une entrée de conducteur neutre (entrée N) qui sont toutes deux reliées au câble d'alimentation secteur, ainsi qu'une sortie de conducteur de phase (sortie L) et une sortie de conducteur neutre (sortie N) qui sont toutes deux reliées au côté consommateur d'un utilisateur du réseau, et comprennent en outre un conducteur de terre, l'entrée de conducteur de phase (entrée L) étant connectée respectivement en dérivation à l'entrée de conducteur neutre (entrée N) et à la sortie de conducteur de phase (sortie L), et le conducteur de terre étant connecté à l'entrée de conducteur neutre (entrée N).

10. Appareil de mesure inviolable selon la revendication 7, dans lequel l'entrée analogique (80) comprend un transformateur de courant en manganine (CT) de l'entrée de conducteur de phase (L) interposé entre l'entrée de conducteur de phase (L) et la sortie de conducteur neutre (N), un transformateur de courant (CT) de l'entrée de conducteur neutre (N) et un transformateur de potentiel (PT), chaque entrée interposée respectivement entre l'entrée de conducteur de phase (L) ou l'entrée de conducteur neutre (N) et la sortie étant reliée de manière individuelle au processeur (30), ou dans lequel

l'entrée analogique comprend un transformateur de courant en manganine (CT) de l'entrée de conducteur de phase (L) interposé entre l'entrée de conducteur de phase (L) et la sortie de conducteur neutre (N), un transformateur de courant (CT) de l'entrée de conducteur neutre (N) et un transformateur de potentiel (PT), chaque entrée interposée respectivement entre l'entrée de conducteur de phase (L) ou l'entrée de conducteur neutre (N) et chaque sortie étant reliée de manière individuelle au processeur (30).

11. Appareil de mesure inviolable selon la revendication 7, dans lequel le circuit abaisseur (70) comprend un circuit abaisseur pour résistance et capacité dont l'entrée est reliée à l'entrée de conducteur de phase (L), ainsi qu'un échantillonneur de courant et un stabilisateur de tension dont l'entrée est reliée respectivement au circuit abaisseur pour résistance et capacité et à l'échantillonneur de courant, et dont la sortie est reliée à l'appareil testeur de courant (90), ou dans lequel

le circuit abaisseur comprend un circuit abaisseur pour résistance et capacité dont la borne d'entrée est reliée à l'entrée de conducteur de phase (L), et un stabilisateur de tension dont la borne d'entrée est reliée respectivement au circuit abaisseur pour résistance et capacité, et dont la sortie est reliée à l'appareil testeur de courant (90).

12. Appareil de mesure watts-heure, lequel peut être interposé entre le câble d'alimentation secteur et le côté consommateur d'un utilisateur du réseau et lequel comprend : le dispositif de lecture proche infrarouge selon l'une quelconque des revendications 1 à 6, un boîtier d'appareil de mesure (2) assemblé à celui-ci, dans le boîtier d'appareil de mesure étant fixés les bornes conductrices, un processeur et un communicateur infrarouge (201) relié électriquement à celui-ci, dans le boîtier d'appareil de mesure étant fixée une pluralité de cylindres métalliques (1) dont l'orientation se trouve dans l'alignement des cylindres magnétiques (3) qui sont fixés dans le dispositif de lecture proche infrarouge et s'attirent les uns les autres.

FIG.1

FIG. 2A

FIG. 2B

FIG.3

FIG.4

FIG.5

FIG.6

FIG.7

FIG.8

FIG.9

FIG.10

EP 2 955 528 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202159083 U
- CN 202119810 U